(19) Europäisches Patentamt
European Patent Office
Office européen des brevets

(11) **EP 4 527 979 A1**

(12) **EUROPEAN PATENT APPLICATION**
published in accordance with Art. 153(4) EPC

(43) Date of publication:
26.03.2025 Bulletin 2025/13

(21) Application number: 23807628.5

(22) Date of filing: 16.05.2023

(51) International Patent Classification (IPC):
C23C 26/00 (2006.01)          C23C 14/06 (2006.01)
F16C 19/16 (2006.01)          F16C 33/32 (2006.01)
F16C 33/58 (2006.01)

(52) Cooperative Patent Classification (CPC):
C23C 14/06; C23C 26/00; F16C 19/16; F16C 33/32;
F16C 33/58

(86) International application number:
PCT/JP2023/018229

(87) International publication number:
WO 2023/224026 (23.11.2023 Gazette 2023/47)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 19.05.2022  JP 2022082651
12.05.2023  JP 2023079728

(71) Applicant: NTN Corporation
Osaka-shi Osaka 530-0005 (JP)

(72) Inventors:
• YAGITA, Kazuhiro
  Kuwana-shi, Mie 511-0867 (JP)
• OHKI, Chikara
  Kuwana-shi, Mie 511-0867 (JP)

(74) Representative: Henkel & Partner mbB
Patentanwaltskanzlei, Rechtsanwaltskanzlei
Maximiliansplatz 21
80333 München (DE)

(54) **RIGID-FILM-COATED OBJECT, MACHINE COMPONENT, AND BEARING**

(57)      Provided are: a rigid-film-coated object having hydrogen embrittlement resistance and wear resistance and having excellent unsusceptibility to separation; and a machine component and a bearing which include the rigid-film-coated object. The rigid-film-coated object 1 comprises a base 2 and a rigid film 3 for inhibiting hydrogen atoms from infiltrating and diffusing formed on a surface of the base 2, wherein the ratio of the Vickers hardness of the rigid film 3 to the Vickers hardness of the base 2 is 0.90-1.20, the Vickers hardness of the base 2 and the Vickers hardness of the rigid film 3 are 500-1,000 Hv each, and the rigid film 3 is an Ni coating film.

Fig.1

## Description

TECHNICAL FIELD

The present invention relates to a hard film formed body having a hard film on a surface of a base material, and a machine component and a bearing using the same.

BACKGROUND ART

In recent years, lightweight and high strength are required to machine components used in automobiles, industrial machines, etc. Such a machine component is often used in a hydrogen entering environment. For example, when a rolling component such as a rolling bearing and a gear is used in a condition in which water enters lubricant or a condition with sliding, water or the lubricant is decomposed to generate hydrogen. When the hydrogen enters steel, early damage due to hydrogen embrittlement might be caused.

Generally, the following techniques have been disclosed to deal with such hydrogen embrittlement. For example, Patent Document 1 discloses a rolling component in which a steel material within a specified chemical component range is carbonitrided and fine-granulated so that carbonitride is dispersed and deposited. This configuration deals with the hydrogen embrittlement against trace hydrogen derived from lubricant. Further, Patent Document 2 discloses a material resistant to hydrogen embrittlement. The material is formed of a Ni base alloy or a Fe-Ni base alloy and includes an aging part and a hydrogen embrittlement suppression layer exposed to hydrogen. The tensile strength of the aging part is more than 1,000 MPa.

Further, a technique has been disclosed that improves wear resistance by forming a hard film on a surface of a base material to deal with the hydrogen embrittlement. For example, Patent Document 3 discloses a rolling bearing having a Ni coating film formed on a rolling surface. The rolling bearing of Patent Document 3 prevents hydrogen from entering steel of the bearing by the Ni coating film and suppresses a short-lifetime flaking by the hydrogen embrittlement, so that the lifetime of the rolling bearing is improved.

PRIOR ART DOCUMENT

PATENT DOCUMENT

Patent Document 1: JP 2010-043320 A
Patent Document 2: JP 2010-174360 A
Patent Document 3: JP 2005-069273 A

SUMMERY OF THE INVENTION

PROBLEMS TO BE SOLVED BY THE INVENTION

In recent years, hydrogen is paid attention to instead of fossil fuels as an energy source. Hydrogen does not generate carbon dioxide ($CO_2$) but only water when used as an energy source, so that hydrogen is expected as clean energy. It is expected that hydrogen is used widely in the whole society in future, and thus hydrogen usable devices (for example, a ball valve or a compressor for hydrogen stations) may become common. Machine components such as a bearing that are used in such hydrogen usable devices may be used in an environment exposed to hydrogen, and in such a case, the early flaking caused by the hydrogen embrittlement might be promoted due to the presence of hydrogen supplied from the outside. Thus, a measure against the hydrogen embrittlement becomes more important.

For example, Patent Document 1 employs the steel within a specified chemical component range as a measure against the trace hydrogen derived from lubricant, however such a measure might be insufficient in an environment exposed to hydrogen such as a hydrogen gas atmosphere. Further, Patent Document 3 discloses that the rolling bearing can be favorably used also in the hydrogen atmosphere, however it merely shows the lifetime extending effect in the steam atmosphere in the actual test, and thus the effect is not clear in the hydrogen atmosphere.

Patent Document 2 discloses the material resistant to the hydrogen embrittlement, such as a piping for high pressure hydrogen gas that is used in an environment exposed to hydrogen. In Patent Document 2, the whole of the material is formed of the Ni base alloy or the Fe-Ni base alloy in order to avoid the rapid degradation of the function thereof due to the flaking of the coating film on the surface, however it might be high in cost compared to a general steel.

An object of the present invention is, in order to solve such problems, to provide a hard film formed body that improves hydrogen embrittlement resistance and wear resistance and has superior flaking resistance, and a machine component and a bearing using the same.

MEANS FOR SOLVING THE PROBLEMS

A hard film formed body of the present invention includes a base material, and a hard film that suppresses entering and diffusing of a hydrogen atom, on a surface of the base material. (A) A ratio of the Vickers hardness of the hard film to the Vickers hardness of the base material is 0.90-1.20, or (B) the thickness of the hard film is 0.1 $\mu$m or more and less than 3 $\mu$m. Here, a configuration that fulfills both features (A) and (B) is also encompassed by the present invention.

The hard film formed body may fulfill the feature (A), and the Vickers hardness of each of the base material and the hard film may be 500-1,000 Hv.

The hard film formed body may fulfill the feature (A), and the hard film that suppresses the entering and diffusing of the hydrogen atom may be a Ni coating film. The Ni coating film may include a Ni-P-B coating film that contains Ni by 90 mass% or more.

In the electrochemical hydrogen permeation method using a specimen formed of the hard film formed body (the thickness of the base material is 1 mm), as each of areas of the specimen that are in contact with electrolytic solutions in a cathode bath and an anode bath, respectively, is set to 3.14 cm$^2$ and the electrolysis is performed at a current density at the side of the anode bath of 1 mA/cm$^2$, the extension time of the Breakthrough time of the specimen may be 0.4 times or more as long as the Breakthrough time of a target formed of the base material having the thickness of 1 mm.

The hard film formed body may fulfill the feature (A), and an intermediate layer and a diamond-like carbon (DLC) layer may be formed on the surface of the hard film.

The hard film formed body may fulfill the feature (A). The ratio of the Vickers hardness may be 0.95-1.05. The Vickers hardness of each of the base material and the hard film may be 700-800 Hv. The hard film that suppresses the entering and diffusing of the hydrogen atom may be a Ni coating film. The Ni coating film may include a Ni-P-B coating film that contains Ni by 90 mass% or more. An intermediate layer and a DLC layer may be formed on the surface of the hard film.

The yield stress of the base material may be 1 GPa or more.

The hard film formed body may fulfill the feature (B), and the hard film that suppresses the entering and diffusing of the hydrogen atom may be a tungsten carbide (WC) film. The thickness of the WC film may be 0.2 $\mu$m or more and less than 1 $\mu$m.

A machine component of the present invention uses the hard film formed body of the present invention. The machine component may be a bearing member.

A bearing of the present invention may use the bearing member.

EFFECT OF THE INVENTION

The hard film formed body of the present invention includes the hard film that suppresses the entering and diffusing of the hydrogen atom, on the base material, and (A) the ratio of the Vickers hardness of the hard film to the Vickers hardness of the base material is 0.90-1.20 or (B) the thickness of the hard film is 0.1 $\mu$m or more and less than 3 $\mu$m. Accordingly, the hard film formed body can improve the hydrogen embrittlement resistance and the wear resistance and have superior flaking resistance.

The hard film formed body fulfills the feature (A) and the Vickers hardness of each of the base material and the hard film is 500-1,000 Hv. Accordingly, the above-described ratio can be set easily in the specified range while securing the wear resistance of the hard film formed body.

The hard film formed body fulfills the feature (A) and the hard film is the Ni coating film, and in particular, the Ni coating film includes the Ni-P-B coating film that contains Ni by 90 mass% or more. Accordingly, the hard film formed body having more superior wear resistance can be realized.

The hard film formed body fulfills the feature (A) and the intermediate layer and the DLC layer are formed on the surface of the hard film. Accordingly, the hard film formed body has more superior wear resistance, and the hydrogen embrittlement resistance can be improved by these layers. Further, the intervened intermediate layer can improve the adhesiveness between the hard film and the DLC layer, and the hard film formed body having superior flaking resistance as a whole can be realized.

The hard film formed body fulfills the feature (B) and the hard film that suppresses the entering and diffusing of the hydrogen atom is the WC film. Accordingly, as described in Example below, the entering and diffusing of the hydrogen atom can be favorably suppressed by a thin film compared to the Ni coating film. Further, the thickness of the WC film is 0.2 $\mu$m or more and less than 1 $\mu$m. Accordingly, the hard film formed body having more superior flaking resistance can be realized.

BRIEF DESCRIPTION OF THE DRAWINGS

Fig. 1 is a general sectional view showing a first embodiment of a hard film formed body according to the present invention.
Fig. 2 is a general sectional view showing a second embodiment of the hard film formed body according to the present invention.
Fig. 3 is a sectional view showing an example of a bearing according to the present invention.
Fig. 4 is a sectional view showing a hydrogen circulating pump using the bearing according to the present invention.
Fig. 5 is a sectional image of a structure of the hard film formed body of Example 1.
Fig. 6 is a general view showing an electrochemical hydrogen permeation test.
Figs. 7(a) and 7(b) are views showing an outline of the electrochemical hydrogen permeation test.
Fig. 8 is a sectional image of a structure of the hard film formed body of Example 3.
Fig. 9 is a graph showing ionizing currents of Example and Comparative example.
Figs. 10(a) and 10(b) are graphs showing ionizing currents of Example and Comparative example.

MODE FOR CARRYING OUT THE INVENTION

Hereinafter, a hard film formed body according to the present invention is described with reference to the drawings. The hard film formed body of the present invention is used in a machine component or the like, in particular a bearing used in a hydrogen entering environment. The hydrogen entering environment denotes an environment in which or various types of hydrogen such as hydrogen gas or water in a use environment and hydrogen atom in lubricant possibly enters a base material and diffuses.

First embodiment

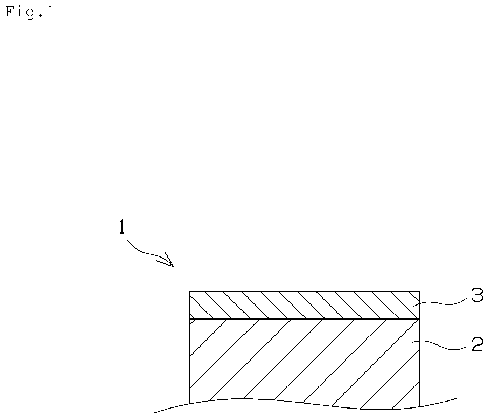

Fig. 1 is a general sectional view of a first embodiment of a hard film formed body according to the present invention. As shown in Fig. 1, a hard film formed body 1 has a base material 2 and a hard film 3 formed on a surface of the base material 2. The hard film 3 has a function that suppresses entering and diffusing of hydrogen atom. For example, the hard film 3 delays the entering of the hydrogen into the base material 2 and the diffusing of the hydrogen. With this, the hydrogen embrittlement caused in the base material 2 can be delayed. The hard film 3 is formed of a material different from that of the base material 2.

In the present invention, (A) a ratio of the Vickers hardness of the hard film 3 to the Vickers hardness of the base material 2 (Vickers hardness (Hv) of the hard film 3 / Vickers hardness (Hv) of the base material 2, hereinafter also simply referred to as a hardness ratio) is 0.90-1.20, or (B) the thickness of the hard film 3 is 0.1 or more and less than 3 $\mu$m. With this, the adhesiveness of the hard film 3 to the base material 2 becomes superior, and the hard film 3 can stably show the hydrogen embrittlement resistance and the wear resistance. In a case in which the feature (A) is fulfilled, the hardness ratio is preferably 0.90-1.10, more preferably 0.95-1.05, further more preferably 0.98-1.02. The hardness ratio may be more than 1.00.

The base material 2 employs any steel material generally used. Examples of the base material 2 includes high carbon chromium bearing steel (SUJ1, SUJ2, SUJ3, SUJ4, SUJ5 and the like; JIS G 4805), cement steel (SCr420, SCM420 and the like; JIS G 4053), and stainless steel (SUS440C and the like; JIS G 4303). The base material 2 need not necessarily employ a special material or a special heat treatment against the hydrogen embrittlement.

The Vickers hardness of the base material 2 (the Vickers hardness of the surface on which the hard film 3 is formed) is preferably 500-1,000 Hv, more preferably 600-900 Hv, further more preferably 700-800 Hv. With the Vickers hardness of the base material 2 within the above-described range, for example, the hardness ratio of (A) can be easily set in the specified range while securing the wear resistance of the hard film formed body.

The base material 2 may be hardened by a heat treatment before forming the hard film 3. Further, a nitride layer may be formed by a nitriding treatment. An example of the nitriding treatment includes a plasma nitriding treatment that hardly generates an oxide layer that deteriorates the adhesiveness, on the surface of the base material. Further, a pretreatment may be applied to the base material 2 for improving the adhesiveness of the hard film 3 to the base material 2. Examples of the pretreatment include a degreasing treatment using a solvent or an alkali solution, and an acid immersing treatment.

The surface roughness Ra of the base material 2 is, for example, 0.1 $\mu$m or less, and preferably 0.05 $\mu$m or less. Various machining treatment (a surface finishing treatment and the like) may be performed in order to adjust the surface roughness Ra of the base material 2.

The hydrogen embrittlement affects a steel material much more as its strength is higher. In particular, delayed fracture is remarkable in the high strength steel having a yield stress of 1 GPa. However, the hard film formed body of the present invention forms the following hard film or a DLC layer on the surface of the steel material so that the delayed fracture due to the hydrogen embrittlement can be favorably suppressed.

The hard film 3 may be a coating film that is capable of suppressing the entering and diffusing of the hydrogen atom, and thus examples of the hard film 3 include a Ni coating film containing Ni as a main component, a Cu coating film containing Cu as a main component, a Zn coating film containing Zn as a main component, a WC film, and a combination thereof. Of these coating films, the Ni coating film or the WC film is preferable as the hard film 3 because they can delay the entering and diffusing of hydrogen such as hydrogen gas or water in a use environment and hydrogen atom in lubricant into the base material 2. Further, the Ni coating film is preferable as the hard film 3 in the configuration that fulfills the above-described feature (A), and the WC film is preferable as the hard film 3 in the configuration that fulfills the above-described feature (B).

Examples of the Ni coating film include a Ni-P coating film, a Ni-B coating film, a Ni-P-B coating film, a Ni-P-B-SiC dispersion coating film, and a combination thereof. These Ni coating films may be formed by a physical vapor deposition (PVD) method such as an ion plating method and a sputtering method, and a plating method such as an electroplating method and an electroless plating method. For example, in the electroless plating method, an electroless plating coating film is formed using a plating bath including various reducers in a nickel salt. In particular, the hard film 3 is preferably a Ni plating coating film, and the Ni plating coating film preferably includes the Ni-P-B coating film.

The Ni-P-B coating film is a complex coating film of Ni, P and B and is formed by the electroless plating method. In the Ni-P-B coating film, the content of Ni is, for example, 90 mass% or more, preferably 95 mass% or more, and more preferably 97 mass% or more. In the especially preferable composition of the Ni-P-B coating film, the content of Ni is 97 mass% or more, the content of P is 1-3 mass% and the content of B is 1 mass% or less. This composition may be appropriately adjusted based on the characteristics required to the coating film. The Ni-P-B coating film is harder and more superior in the wear resistance than, for example, the Ni-P coating film. An example of the Ni-P-B coating film as a commercially available product includes Kaniboron (product name) produced by JAPAN KANIGEN CO.,LTD.

In the relation between the heat treatment temperature and the hardness after the plating treatment, the hardness of the Ni-P-B coating film becomes higher as the heat treatment (baking) temperature is higher within a range up to 400°C. This is because the crystallizing of Ni is promoted by the heat treatment. The structure of the Ni-P-B coating film is a fine crystal (polycrystal), and the peak derived from Ni is observed in an X-ray diffraction pattern. Further, the Ni-P-B coating film is harder than the Ni-P coating film. The Ni-P-B coating film shows the Vickers hardness HV of 700 or more in deposition, and the Vickers hardness HV of 800 or more in the heat treatment at the temperature of 200°C.

In the configuration that fulfills the above-described feature (A), the Vickers hardness of the hard film 3 is preferably 500-1,000 Hv, more preferably 600-900 Hv, and further more preferably 700-800 Hv.

For example, in a case in which the hard film 3 includes the Ni-P-B coating film, the hardness of the coating film becomes higher as the heat treatment temperature is higher, while the hardness of the base material 2 obtained through hardening becomes lower, and thus the strength of the whole of the hard film formed body might be deteriorated. Thus, a steel material hardened by the heat treatment is employed and the Ni-P-B coating film formed on the surface is subjected to the aging treatment at an appropriate temperature, so that the steel material and the hard film with enough strength can be obtained. Accordingly, the hard film formed body with enough strength as a whole can be obtained. Further, even in a case in which the steel material is deformed, it can be prevented that only the hard film is yielded and plastically deformed to cause flaking. The aging treatment need not necessarily be executed depending on the hardness of the steel material.

For example, an influence caused by tempering the base material 2 can be reduced by setting the baking temperature for the Ni-P-B coating film to 200°C of less, preferably 180°C or less. In this manner, in producing the hard film 3, it is preferable that the tempering temperature for the base material 2, the required strength of the base material 2, and the hardness required to the hard film 3 on the surface of the base material 2 are appropriately selected so as not to cause disadvantages due to the difference between the hardness of the base material 2 and the hardness of the hard film 3.

In the configuration that fulfills the above-described feature (A), considering the management in producing and a possibility of decreasing of the thickness of the hard film 3 due to wear, the lower limit of the thickness of the hard film 3 is preferably 1 $\mu$m. The upper limit of the hard film 3 is preferably 50 $\mu$m in order to suppress the production cost, the processing time, and the imbalance of the stress in the film. The thickness of the hard film 3 is more preferably 3-30 $\mu$m, and further more preferably 3-10 $\mu$m. The thickness may be set based on the required effect against the hydrogen embrittlement. For example, the thickness of the plating coating film may be adjusted by adjusting the immersing time to the plating bath.

In the configuration that fulfills the above-described feature (B), the WC film may be formed by, for example, the unbalanced magnetron sputtering (UBMS) method using a WC target. The thickness of the WC film is preferably 0.2 $\mu$m or more and less than 1 $\mu$m. The thickness of the WC film may be 0.2-0.6 $\mu$m. The Vickers hardness of the WC film is not especially limited, but may be, for example, 1,000-2,000 Hv. However the Vickers hardness of the WC film may be more than 2,000 Hv.

The hydrogen diffusion coefficient in the hard film 3 is preferably $5.00 \times 10^{-12}$ m$^2$/s or less, may be $1.00 \times 10^{-12}$

$m^2/s$ or less, or $8.00 \times 10^{-13}$ $m^2/s$ or less. The specific range of the hydrogen diffusion coefficient is, for example, $1.00 \times 10^{-13}$ - $8.00 \times 10^{-13}$ $m^2/s$. The hydrogen diffusion coefficient is obtained by an electrochemical hydrogen permeation method. The details will be described in Example below.

As one example of the forming method of the hard film 3, the forming of the Ni-P-B coating film is described. The plating bath including a nickel salt that contains a phosphorus compound and a boron compound as reducing agents is employed. More specifically, examples of the nickel salt include nickel chloride and nickel sulfate, examples of the phosphorus compound include sodium hypophosphite and potassium hypophosphite, and examples of the boron compound include dimethylamino borane and sodium borohydride. The ratio of the nickel salt, the phosphorus compound and the boron compound in the plating bath is appropriately adjusted based on the composition of the plating coating film to be obtained. Further, organic acid such as acetic acid or a chelating agent such as ethylenediaminetetraacetic acid (EDTA) may be added into the plating bath.

pH of the plating bath is preferably 6-7 from a viewpoint of stability and a deposition speed. Further, the temperature of the plating bath is, for example, 60-90°C, and preferably 70-90°C.

The obtained plating coating film is subjected to the heat treatment (baking) to improve the hardness of the film. The heat treatment temperature is, for example, 100-200°C, preferably 100-180°C, and more preferably 120-160°C. The heat treatment time is, for example, 30-120 minutes. The heat treatment is performed in atmosphere with air, inert gas, or reducing gas.

As the property of the hard film formed body 1, in the electrochemical hydrogen permeation method using a specimen formed of the hard film formed body (the thickness of the base material 2 of 1 mm), when each area of the specimen that is in contact with an electrolytic solution in each of an anode bath and a cathode bath is set to $3.14$ $cm^2$ and the electrolysis is performed as the current density at a side of the anode bath of 1 $mA/cm^2$, the extension time of the Breakthrough time of the specimen is preferably 0.4 times or more, more preferably 1.0 time or more, further more preferably 2.0 times or more, 5.0 times or more, or 10.0 times or more as long as the breakthrough time of the target piece formed of the base material 2 having the thickness of 1 mm. The details of the electrochemical hydrogen permeation method will be described in Example. Second embodiment

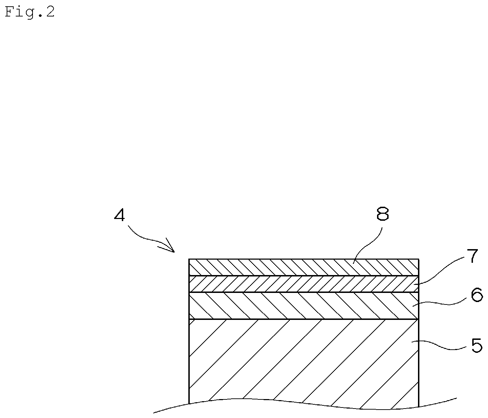

Fig. 2 is a general sectional view showing a second embodiment of a hard film formed body according to the present invention. As shown in Fig. 2, a hard film formed body 4 includes a base material 5, a hard film 6 formed on a surface of the base material 5, an intermediate layer 7 formed on the hard film 6, and a DLC layer 8 formed on the intermediate layer 7. In this case, the coating film formed on the base material 5 has a substantially three-layer structure. The structures of the base material 5 and the hard film 6 are similar to those of the base material 2 and the hard film 3 described in the first embodiment (especially, the configuration that fulfills the above-described feature (A)), and thus the description thereof is omitted.

The intermediate layer 7 is intervened between the hard film 6 and the DLC layer 8. Examples of the intermediate layer 7 include a tungsten carbide (WC) layer, and a mixed layer mainly containing WC and DLC. The WC has an intermediate hardness and an intermediate elastic modulus between the hard film 6 and the DLC layer 8, and thus the concentration of the residual stress after forming the film is hardly caused.

The intermediate layer 7 is preferably a mixed layer mainly containing the WC and the DLC, and further preferably a layer in which the content rate of the WC in the intermediate layer is continuously or stepwise decreased and the content of the DLC in the intermediate layer is continuously or stepwise increased, toward the side of the DLC layer 8 from the side of the hard film 6. With this, superior adhesiveness can be realized on both surfaces at the side of the hard film 6 and the side of the DLC layer 8. Further, the intermediate layer has a structure in which the WC and the DLC are physically bonded to each other, so that the break in the intermediate layer can be prevented. Further, since the content rate of the DLC is higher at the side of the DLC layer 8, superior adhesiveness can be realized between the DLC layer 8 and the intermediate layer 7. In this case, the intermediate layer 7 bonds the DLC, which has a non-adhesive property, to the hard film 6 by the WC using an anchor effect.

The DLC layer 8 mainly contains the DLC. The DLC is a structure of a combination of a graphite structure ($sp^2$) and a diamond structure ($sp^3$), which is an intermediate structure between the graphite structure and the diamond structure. Examples of the forming method of the DLC layer 8 include a physical vapor deposition method such as a sputtering method and an ion plating method, a chemical vapor deposition method, and the UBMS method.

The DLC layer 8 preferably includes a relaxing layer potion (not shown) at an adjacent side of the intermediate layer 7. The relaxing layer portion is formed by continuously or stepwise changing at least one of film forming condition parameters (an introduction amount of hydrogencarbonate-based gas, a vacuum degree, a bias voltage) in the UBMS method in order to avoid rapid change of the parameters in a case in which, for example, the parameters are different between the intermediate layer 7 and the DLC layer 8. More specifically, each parameter is continuously or stepwise changed within a range between a start point as the film forming condition parameter for forming the uppermost layer of the intermediate layer 7 and an end point as the film forming condition parameter for forming the DLC layer 8. With this, the rapid change of the properties (hardness, elastic modulus, etc.) between the intermediate layer 7 and the DLC layer 8 is not caused, and thus superior adhesiveness between the intermediate layer 7 and the DLC layer 8 can be realized. For example, when the bias voltage is continuously or stepwise increased, the composition ratio of the graphite structure ($sp^2$) and the diamond structure ($sp^3$) in the DLC structure becomes close to the diamond structure ($sp^3$), to be the gradient hardness (the hardness is increased).

In the hard film formed body 4 of the second embodiment, the Vickers hardness of the DLC layer 8, which is a surface layer, is, for example, 1,000-3,000 Hv.

The total film thickness of the intermediate layer 7 and the DLC layer 8 is preferably 1.0-5.0 $\mu$m, and more preferably 1.0-3.0 $\mu$m. With the total film thickness within the above-described range, the wear resistance and the mechanical strength can be improved and the flaking of the intermediate layer 7 and the DLC layer 8 can be suppressed. Further, the total film thickness of the intermediate layer 7 and the DLC layer 8 is preferably smaller than the film thickness of the hard film 6. In the hard film formed body 4, the total thickness of the coating film formed on the base material 5 is preferably 3.0-30 $\mu$m, and more preferably 3.0-10 $\mu$m.

As one example of the forming method for the intermediate layer 7 and the DLC layer 8, a method using a UBMS device using Ar gas as sputtering gas is described.

For example, in a case in which the intermediate layer 7 is a mixed layer mainly containing the WC and the DLC, a film is formed while continuously or stepwise increasing the sputtering electric power applied to a graphite target as a carbon supply source and decreasing the electric power applied to a WC target, so that a layer is formed having a gradient composition in which the content rate of the WC is decreased and the content rate of the DLC is increased toward the DLC layer 8. The degree of vacuum in the UBMS device (the film forming chamber) in forming the intermediate layer 7 is, for example, 0.2-1.2 Pa. The bias voltage applied to the base material is, for example, 20-100 V.

The DLC layer 8 is formed by depositing the carbon atoms supplied from the carbon supply source, on the intermediate layer 7 as both the graphite target and the hydrogencarbonate-based gas (methane gas, acetylene gas, benzene, etc.), which are the carbon supply sources, are used together and the rate of the introduction amount of the hydrogencarbonate-based gas is set to, for example, 1-15 relative to 100 of the introduction amount of the Ar gas. The degree of vacuum in the device is, for example, 0.2-0.9 Pa.

In the example shown in Fig. 2, the intermediate layer 7 is intervened between the hard film 6 and the DLC layer 8, however the intermediate layer 7 may be omitted. Further, the hard film formed body of the present invention is not limited to the examples shown in Figs. 1 and 2. For example, the intermediate layer 7 and the DLC layer 8 may be repeatedly laminated on the hard film 6. Further, the DLC layer may be formed on the surface of the hard film that fulfills the above-described feature (B) in the first embodiment. In this case, the hard film formed body has, for example, a base material, a WC film formed on a surface of the base material, and a DLC layer formed on the WC film.

Usage of hard film formed body

The usage of the hard film formed body of the present invention is not especially limited, but may be preferably applied to a machine component because of its superior mechanical properties. The machine component is used in a rolling portion or a sliding portion of a device. Specific examples of the machine component include a sliding component, a bearing component, a roll material for rolling, a compressor vane, an engine component such as a gas turbine vane, a cutting tool (cutting tip), and a gear. Examples of the bearing component include a raceway ring such as an inner ring and an outer ring, a bearing rolling element, and a cage. The bearing of the present invention employs the hard film formed body of the present invention in the bearing component. Examples of the bearing include a rolling bearing, a sliding bearing (a spherical bushing), a linear guide bearing, a ball bearing, and a linear bearing.

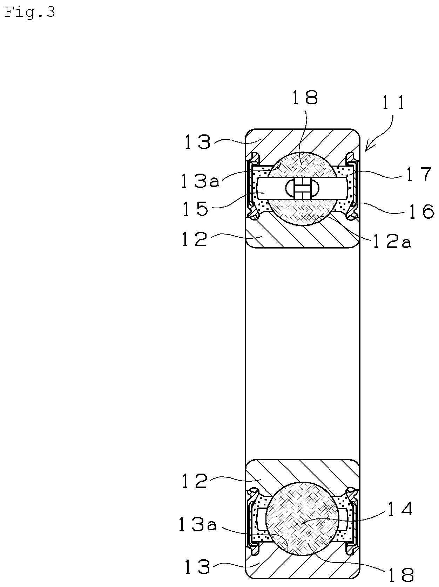

One example of a bearing of the present invention is described with reference to Fig. 3. Fig. 3 is a sectional view of a deep groove ball bearing using the hard film formed body of the first embodiment as a rolling element. A deep groove ball bearing 11 includes an inner ring 12 having an inner ring raceway surface 12a on an outer peripheral surface, an outer ring 13 having an outer ring raceway surface 13a on an inner peripheral surface, and a plurality of balls (rolling elements) 14 rolling between the inner ring raceway surface 12a and the outer ring raceway surface 13a. The balls 14 are retained by a cage 15 at the same intervals. Both end openings in an axial direction of the inner and outer rings are sealed by seal members 16, and grease 17 is filled in a bearing space.

In the rolling bearing shown in Fig. 3, a hard film 18 is formed on the whole spherical surface of the ball 14. In the example shown in Fig. 3, the hard film 18 is formed only on the ball 14, but may be formed on a surface (a portion) of other bearing component such as the inner ring 12 and the outer ring 13 depending on the type of the bearing and its usage. In a configuration in which two or more components come into contact with or slide to each other, it is preferable that the hard film formed body is used in at least one of them.

The bearing of the present invention can favorably suppress the early flaking due to the hydrogen embrittlement when used in a hydrogen entering environment because at least a portion of the bearing component is formed of the hard film formed body of the present invention. Thus, the bearing of the present invention is favorable as a bearing used in an environment in which the early flaking due to the hydrogen embrittlement is easily caused.

For example, the bearing of the present invention is used as a bearing for a transaxle of vehicles (fuel cell vehicle (FCV), electric vehicle (EV), etc.), a transmission of vehicles (continuously variable transmission, etc.), and a vehicle motor (for a driving device or a transmission). The bearing of these usages are required to be endurable against a rapid change of the rotation speed in accordance with gear shift, a high rotation, or a high load. Further, in these devices, lubrication oil with low viscosity is used to reduce power loss. In such a severe use environment, wear of the raceway ring or the rolling element is promoted by sliding. When a steel newly surface is generated by the wear, water or a component of the lubricant is decomposed to generate hydrogen and the hydrogen enters the steel, so that the early flaking due to the hydrogen embrittlement is easily caused. Further, in the fuel cell vehicle, hydrogen leaked from hydrogen equipment might promote the hydrogen embrittlement of the rolling bearing.

Further, the bearing of the present invention is used as a bearing for hydrogen usable devices. In particular, the bearing of the present invention is favorable as a bearing used in an environment exposed to hydrogen supplied from an outside. It is expected that a case is increased that the bearing is used in a hydrogen atmosphere (including a mixed atmosphere with which hydrogen is mixed) due to the increase of the use of hydrogen in future. In such a case, it is considered that not only hydrogen caused by the decomposition of the grease (hydrogen of internal factor) but also hydrogen supplied from the outside (hydrogen of external factor) affects the early flaking due to the hydrogen embrittlement. The bearing of the present invention employs the hard film formed body to effectively suppress the early flaking even in a case in which the early flaking due to the hydrogen embrittlement is concerned compared to the conventional case.

Examples of the hydrogen usable device include a ball valve and a compressor for hydrogen stations. The type of the compressor is not especially limited, but may be a reciprocating (reciprocation) type, a rotation (screw) type, a centrifugal type, or an axial flow type. Further, the hydrogen usable device also includes a high-pressure-hydrogen pressure reducing valve or a hydrogen circulating pump for the above-described fuel cell vehicles.

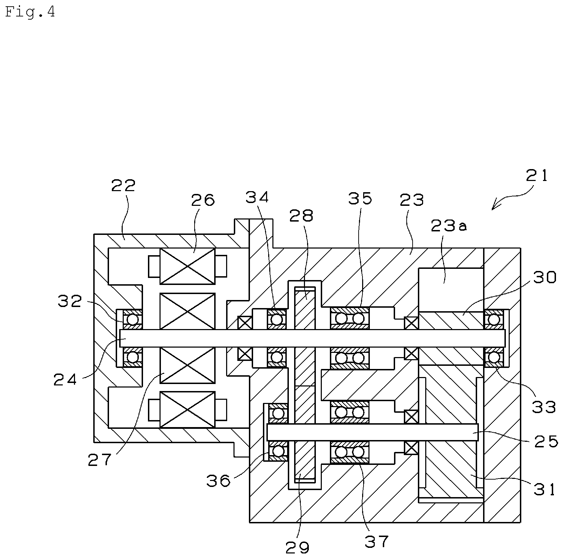

Fig. 4 shows a sectional view of a hydrogen circulating pump to which the bearing of the present invention is applied. A hydrogen circulating pump 21 includes a motor housing 22, a pump housing 23, rotational shafts 24, 25, a motor stator 26, a motor rotor 27, gears 28, 29, rotors 30, 31, and rolling bearings 32, 33, 34, 35, 36, 37.

The motor housing 22 is mounted to the pump housing 23. One end portion of the rotational shaft 24 is disposed in the motor housing 22, and the other end portion of the rotational shaft 24 is disposed in the pump housing 23. The one end portion of the rotational shaft 24 is rotatably supported by the rolling bearing 32 disposed in the motor housing 22, and the other end portion of the rotational shaft 24 is rotatably supported by the rolling bearing 33 disposed in the pump housing 23. The rotational shaft 24 is rotatably supported by the rolling bearings 34, 35 disposed in the pump housing 23, at a portion between the one end portion and the other end portion.

The rotational shaft 25 is disposed in the pump housing 23. One end portion of the rotational shaft 25 is rotatably supported by the rolling bearing 36 disposed in the pump housing 23. The rotational shaft 25 is rotatably supported by the rolling bearing 37 disposed in the pump housing 23, at a portion separate from the one end portion.

The motor stator 26 is disposed in the motor housing 22. The motor rotor 27 is mounted to the rotational shaft 24 to face the motor stator 26. The rotational shaft 24 is rotated by the motor stator 26 and the motor rotor 27. The gear 28 is mounted to the rotational shaft 24. The gear 29 is mounted to the rotational shaft 25. A rotation of the rotational shaft 24 is transmitted to the rotational shaft 25 via the gears 28, 29. The gear 28 is disposed between the rolling bearing 34 and the rolling bearing 35. The gear 29 is disposed between the rolling bearing 36 and the rolling bearing 37.

A pump chamber 23a is formed in the pump housing 23. The rotors 30, 31 are disposed in the pump chamber 23a. The rotor 30 is mounted to the rotational shaft 24. The rotor 31 is mounted to the rotational shaft 25. When the rotor 30 is rotated in accordance with the rotation of the rotational shaft 24 and the rotor 31 is rotated in accordance with the rotation of the rotational shaft 25, hydrogen is sucked into the pump chamber 23a and the hydrogen is discharged from the pump chamber 23a.

In the example shown in Fig. 4, each of the rolling bearings 32, 33, 34, 36 is a deep groove ball bearing. The rolling bearing 33 is used in an environment exposed to hydrogen supplied from the outside (for example, hydrogen atmosphere). Each of the rolling bearings 35, 37 is a double-row angular ball bearing. In the example shown in Fig. 4, at least one of the rolling bearings 32, 33, 34, 35, 36, 37 is the bearing of the present invention.

EXAMPLE

The present invention is further specifically described with reference to Examples and Comparative examples, however the present invention is not limited to Examples and Comparative examples.

Examples 1 and 2, Comparative example 1

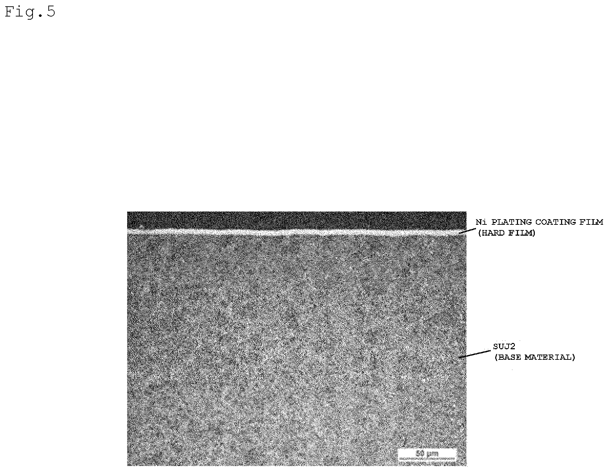

SUJ2 having the thickness of approximately 1 mm is hardened and then tempered at 190°C so that a steel plate having the hardness of 61.5 HRC (730 Hv) is prepared. In each of Examples 1 and 2, a Kaniboron plating treatment, which is one kind of the electroless plating methods, is subjected to the surface of the steel plate. The composition of the obtained coating film includes Ni of 97-98 mass%, P of 1.5-2.5 mass%, and B of 0.05-0.5 mass%. After the Kaniboron plating treatment, the aging hardening is performed by the baking at 150°C for one hour, so as to form the electroless Ni-P-B plating coating film as the hard film. The thickness of the Ni plating coating film is 5 $\mu$m (Example 1) or 30 $\mu$m (Example 2). Fig. 5 shows a sectional image of a structure of the hard film formed body of Example 1. Technically, the Ni plating coating film has a structure in which the electroless Ni-P plating coating film is formed on the base material and the electroless Ni-P-B plating coating film is formed thereon (the uppermost surface side). In Comparative example 1, the steel plate of SUJ2 is employed to which the hardening and the tempering are performed while the above-described plating treatment is not performed.

Hardness test

The Vickers hardness of the hard film of each of the specimens of Examples 1 and 2 is measured based on JIS Z 2244. According to the measurement, the hardness of the hard film of Example 1 is 724 Hv, and the hardness of the hard film of Example 2 is 735 Hv. These are substantially the same as the hardness of SUJ2 (the base material). A ratio of the Vickers hardness of the hard film to the Vickers hardness of the base material is shown in Table 1. The yield stress of the base material is approximately 1,200-1,700 MPa.

Table 1

| | Coating film structure | Hardness of base material | Hardness of hard film | Hardness ratio |
|---|---|---|---|---|
| Comparative example 1 | SUJ2 | 730 Hv | - | - |
| Example 1 | SUJ2 + Ni plating coating film of 5 $\mu$m | 730 Hv | 724 Hv | 0.99 |
| Example 2 | SUJ2 + Ni plating coating film of 30 $\mu$m | 730 Hv | 735 Hv | 1.01 |

Electrochemical hydrogen permeation test

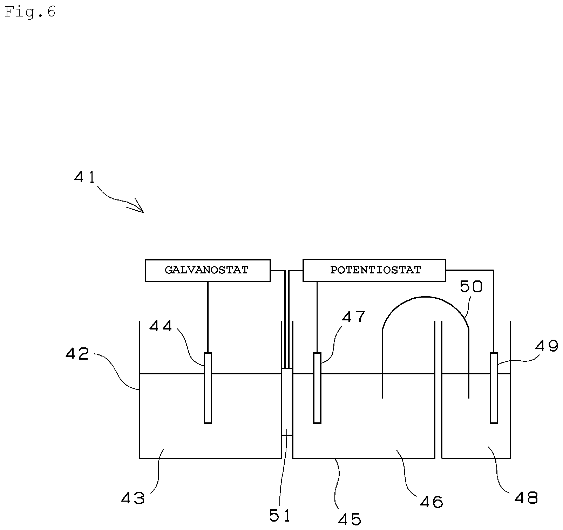

The electrochemical hydrogen permeation is executed to evaluate hydrogen that enters and diffuses in each of the specimens of Examples 1 and 2 and Comparative example 1. Fig. 6 is a general view showing a test device. As shown in Fig. 6, a test device 41 includes a cathode bath 42, an anode bath 45, a cathode electrode 44 (for example, Pt electrode), an anode electrode 47 (for example, Pt electrode), a galvanostat and a potentiostat. The cathode bath 42 and the anode bath 45 are separated by a specimen 51. In Examples 1 and 2, the hard film formed on the specimen 51 is disposed at the side of the cathode bath 42.

An electrolytic solution 43 is accommodated in the cathode bath 42 and the cathode electrode 44 is immersed therein. An electrolytic solution 46 is accommodated in the anode bath 45 and the anode electrode 47 is immersed therein. In this test, the electrolytic solution 43 employs a solution of 0.1N sulfuric acid with thiourea added thereto, and the electrolytic solution 46 employs 1N sodium hydroxide. The galvanostat is connected to the cathode electrode 44 and the specimen 51. The potentiostat is connected to the anode electrode 47, the specimen 51, and a reference electrode 49 (for example, Ag/AgCl electrode). The reference electrode 49 is immersed into a KCl saturated solution 48 and is connected to the anode bath 45 via a salt bridge 50.

In the test device 41, a specified electric potential is applied to a portion between the specimen 51 and the cathode electrode 44 by the galvanostat to perform electrolysis, so that hydrogen is generated on the surface of the specimen 51 at the side of the cathode bath 42. The generated hydrogen enters the specimen 51 from the surface of the specimen 51 at the side of the cathode bath 42. The potentiostat keeps the surface potential of the specimen 51 at the electric potential that oxidizes a hydrogen atom to a hydrogen ion. Thus, the hydrogen atom that enters and diffuses in the specimen from the cathode bath 42 and reaches the surface of the specimen 51 at the side of the anode bath 45 is immediately oxidized to the hydrogen ion, so that ionizing current is generated. In this test, the Breakthrough time method that calculates the diffusion coefficient based on the time until an increase of the ionizing current starts. Specifically, as the time (Breakthrough time) until the increase of the ionizing current starts from the beginning of the test is set to tb and the thickness of the specimen 51 (the total thickness of the base material and the hard film) is set to L, the diffusion coefficient $D_H$ is calculated from the following formula (1) (reference document: Takahiro Kushida, Research on hydrogen embrittlement by electrochemical hydrogen permeation technique, Zairyo-to-Kankyo, 2000, vol. 49, p. 195-200). The measurement of the diffusion coefficient is performed at 20-25°C.

Math 1

$$D_H = \frac{L^2}{15.3 \times tb} \quad \cdots (1)$$

Specifically, as each of areas of the specimen 51 that are in contact with the electrolytic solution 43 and 46 in the cathode bath 42 and the anode bath 45, respectively, is set to 3.14 cm$^2$, the electrolysis is performed at the current density at the side of the anode bath 45 of 1 mA/cm$^2$. The ionizing current of the cathode side is measured at each 0.1 μA so as to determine the increase of the ionizing current. The average of the Breakthrough time and the average of the diffusion coefficient $D_H$ of each of Examples 1 and 2 and Comparative example 1 are shown in Table 2.

Table 2

|  | Coating film structure | Test number | Average ± 2σ of Breakthrough time (s) | Average ± 2σ of diffusion coefficient $D_H$ ($\times$ 10$^{-11}$ m$^2$/s) |
|---|---|---|---|---|
| Comparative example 1 | SUJ2 | 4 | 2,155 ± 559 | 3.16 ± 0.86 |
| Example 1 | SUJ2 + Ni plating coating film of 5 μm | 3 | 3,041 ± 177 | 2.37 ± 0.10 |
| Example 2 | SUJ2 + Ni plating coating film of 30 μm | 3 | 7,958 ± 179 | 0.99 ± 0.03 |

As shown in Table 2, Examples 1 and 2 each including the Ni plating coating film increase in thickness merely by approximately 0.5% and 3%, respectively, compared to Comparative example 1 (SUJ2 having the thickness of 1 mm), while the Breakthrough time thereof are extended by 41% and 269%, respectively. Further, the diffusion coefficient $D_H$ calculated by the Breakthrough time method of Examples 1 and 2 are 75% and 31%, respectively, relative to that of Comparative example 1. Accordingly, the hydrogen is prevented from entering and diffusing by the Ni plating coating film.

Further, the deviation (2σ) of the Breakthrough time of Comparative example 1 is the largest, which is approximately ± 26%. Against this, the deviations of the Breakthrough time of Examples 1 and 2 are ± 6% and ± 2%, respectively. In t-test, there is a significant difference between the Breakthrough time of Comparative example 1 and the Breakthrough time of Examples 1 and 2 by the significance level of 1%, and there is a significant difference between the diffusion coefficients $D_H$ calculated by the Breakthrough times by the significance level of 5%.

The Breakthrough time of each of Examples 1 and 2 and Comparative example 1 is a benchmark as to the time until the hydrogen atom diffuses in a portion at the depth of 1 mm from the surface of the hard film formed body.

The hydrogen diffusion coefficient of the Ni plating coating film is presumed by the finite element method using the hydrogen diffusion coefficient of 3.16 $\times$ 10$^{-11}$ m$^2$/s and the Breakthrough time of Comparative example 1 and the Breakthrough times of Examples 1 and 2 obtained by the above-described electrochemical hydrogen permeation method. As a result, the hydrogen diffusion coefficient of the Ni plating coating film of Example 1 is 4.95 $\times$ 10$^{-13}$ m$^2$/s, and the hydrogen diffusion coefficient of the Ni plating coating film of Example 2 is 2.84 $\times$ 10$^{-13}$ m$^2$/s. Technically, both the hydrogen diffusion coefficients are identical to each other, however there is a difference because of a measurement error or a deviation of the film thickness. The presuming of the hydrogen diffusion coefficient by the finite element method is as below.

(1) As a concentration of the hydrogen at one side of a plate having the thickness of 1 mm is set to 1, the concentration of the hydrogen that diffuses the other side of the plate after the Breakthrough time passes is analyzed (this concentration is presumed as a detection lower limit concentration).
(2) As the concentration of the hydrogen at one side of the plate is set to 1 and the hydrogen diffusion coefficient of Comparative example 1 is applied to SUJ2, the analysis is repeated by appropriately changing the hydrogen diffusion coefficient of the coating film as an unknown quantity until the concentration of the hydrogen diffuses the other side of the plate after the Breakthrough time of Comparative example 1 passes becomes equal to the concentration of the hydrogen calculated in the above-described (1).

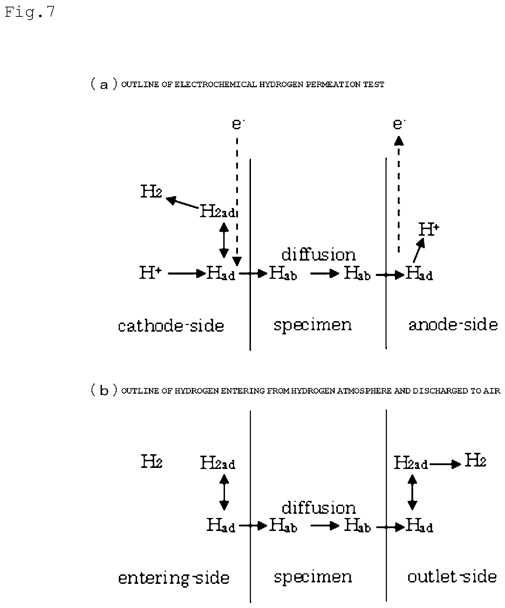

In the above-described electrochemical hydrogen permeation test, the thiourea is added to the electrolytic solution at the cathode side. Thus, as shown in Fig. 7(a), it is expected that $H_{ad}$ is preferentially consumed in an entering reaction of $H_{ad} \rightarrow H_{ab}$ by a mechanism that prevents the hydrogen atoms ($H_{ad}$) that are stuck to the surface from being recombined to become $H_2$. Further, it is presumed that the hydrogen atom follows the reaction path after $H_{2ad}$ when there are excessive $H_{ad}$. Meanwhile, in a case in which the hydrogen is caused to enter the specimen using the hydrogen gas or a strength test such as a fatigue test is executed, the entering and diffusing of the hydrogen is delayed or the strength deterioration due to the hydrogen embrittlement can be prevented also by suppressing a dissociative adsorption reaction of the hydrogen molecule ($H_2 \Leftrightarrow H_{2ad}$ or $H_{2ad} \Leftrightarrow 2H_{ad}$) (see Fig. 7 (b)) . However, in such a case, when the supply source of the hydrogen is not the hydrogen molecule but the hydrogen atom or the hydrogen ion in any molecule, the effect as the hydrogen embrittlement measure might not be shown. Thus, in order to handle various hydrogen supply sources such as the hydrogen atom in water in the use environment and the hydrogen atom in the lubrication oil in addition to the hydrogen gas, in this example, the electrochemical hydrogen permeation test is executed that focuses on the entering and diffusing of the hydrogen.

Example 3

Similar to Example 1, the Kaniboron plating treatment is applied to the surface of the steel plate that has been subjected to the hardening and tempering, so as to form the Ni plating coating film having the thickness of 5 $\mu$m. Further, the WC/DLC coating film as an intermediate layer is formed on the Ni plating coating film, and the DLC coating film is formed on the uppermost surface.

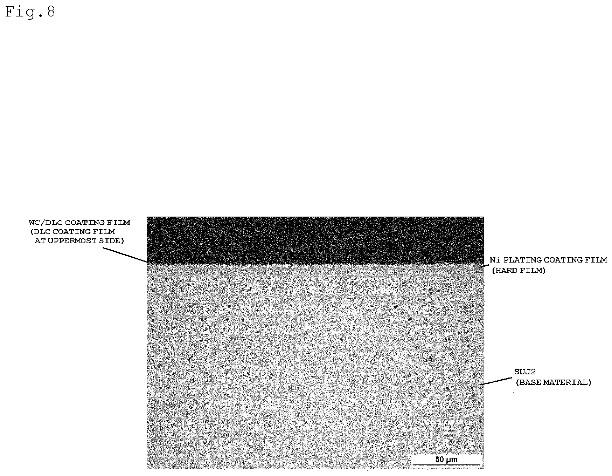

The WC/DLC coating film is formed by the UBMS method. Specifically, the sputtering voltage applied to the WC target and the graphite target is adjusted while supplying methane gas, which is hydrogencarbonate-based gas, so that the composition ratio of the WC and the DLC is inclined to form the WC/DLC gradient layer in which the WC is much at the side of the Ni plating coating film and the DLC is much at the side of the surface. Further, the DLC coating film is also formed by the UBMS method. In this case, the graphite target and the methane gas, which is hydrogencarbonate-based gas, are employed as the carbon supply source. Fig. 8 shows a sectional image of a structure of the hard film formed body of Example 3.

Next, the electrochemical hydrogen permeation test is executed on the specimen of Example 3. Here, in the electrochemical hydrogen permeation test, it is necessary to apply the current on the surface of the specimen and to measure the current. However, the specimen of Example 3 has the DLC coating film, which has extreme high electric resistance, on the surface at the side of the cathode bath that generates the hydrogen to enter the specimen, and thus it is difficult to execute the electrochemical hydrogen permeation test unlike the above-described Example. Thus, the electrochemical hydrogen permeation test is executed after forming a gold vapor deposition film of approximately several nanometers on the DLC coating film to decrease the electric resistance of the uppermost surface. In order to check the capability of preventing the hydrogen permeation of the gold vapor deposition film, the specimen (Comparative example 2) that has the gold vapor deposition film, which is the same as Example 3, on the surface of SUJ2 is employed as the comparative target. The test condition is similar to that of Examples 1 and 2 and Comparative example 1. The result is shown in Table 3.

Table 3

| | Coating film structure [1] | Test number | Average $\pm$ 2$\sigma$ of Breakthrough time (s) | Average $\pm$ 2$\sigma$ of diffusion coefficient $D_H$ ($\times$ 10$^{-11}$ m$^2$/s) |
|---|---|---|---|---|
| Comparative example 2 | SUJ2 | 2 | 2,286 $\pm$ 66 | 2.91 $\pm$ 0.14 |
| Example 3 | SUJ2 + Ni plating coating film of 5 $\mu$m + (WC/DLC coating film + DLC coating film) of 2 $\mu$m | 2 | 810, 650 $\pm$ 265,692 | 0.00882 $\pm$ 0.00290 |

1) the gold vapor deposition film of several nanometers is formed on the uppermost surface of each specimen in order for the measurement in the electrochemical hydrogen permeation test

Comparing Comparative example 2 in Table 3 and Comparative example 1 in Table 2, it is found that the capability of preventing the hydrogen permeation of the gold vapor deposition film is small. As shown in Table 3, Example 3 having the Ni plating coating film, the WC/DLC coating film, and the DLC coating film largely extends the Breakthrough time and largely decreases the diffusion coefficient $D_H$, compared to Comparative example 2. The hydrogen diffusion coefficient of each of the WC/DLC coating film and the DLC coating film is presumed as 1.00 $\times$ 10$^{-15}$ - 1.00 $\times$ 10$^{-14}$ m$^2$/s (specifically, approximately 1.18 $\times$ 10$^{-15}$ m$^2$/s), which is smaller than the hydrogen diffusion coefficient of the Ni plating coating film.

Comparing the result of Example 3 and the results of Examples 1 and 2, the advantageous effect of Example 3 is remarkable. It is found that each of the WC/DLC coating film and the DLC coating film prevents the hydrogen from entering and diffusing, and when the WC/DLC coating film and the DLC coating film are formed on the Ni plating coating film, the effect of the Ni plating coating film is remarkably improved.

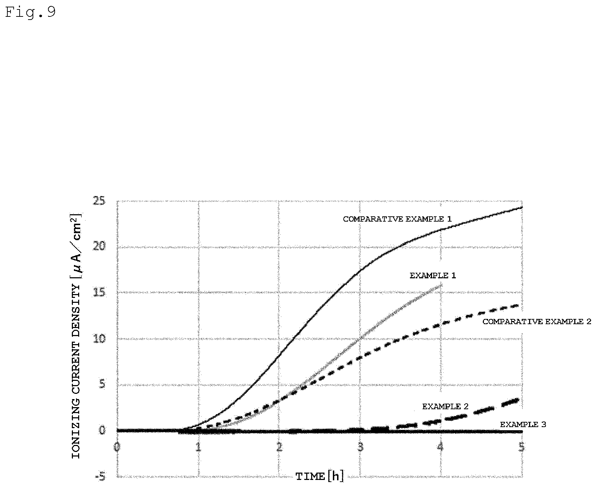

Fig. 9 is a graph summarizing the results of Examples 1 to 3 and Comparative examples 1 and 2. As shown in Fig. 9, the hydrogen embrittlement delaying effect can be shown by forming the Ni plating coating film as the hard film, on the surface of the base material.

Example 4

The WC film having the thickness of 0.4 $\mu$m is formed by the unbalanced magnetron sputtering (UBMS) method, on the surface of SUJ2 (730 Hv) having the thickness of 1 mm, which is Comparative example 1, that has been subjected to the hardening and tempering. The Vickers hardness of the WC film is 1,000-2,000 Hv.

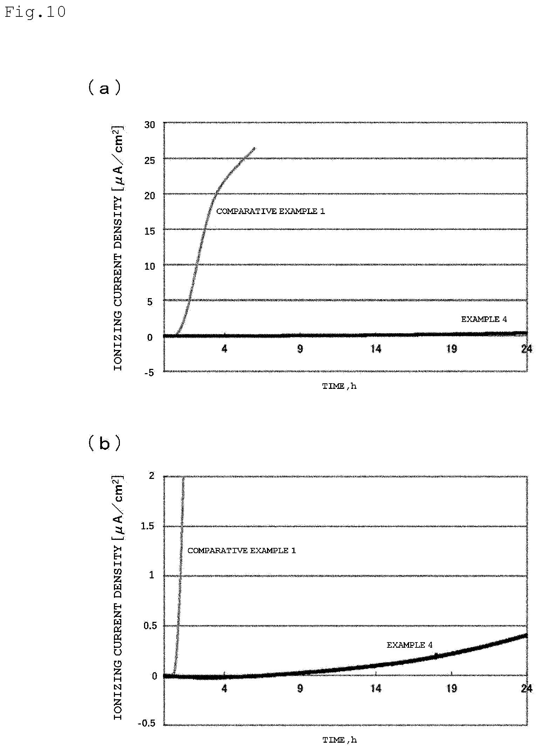

The electrochemical hydrogen permeation test is executed on the obtained specimen of Example 4. The test condition is similar to that of Examples 1 and 2 and Comparative example 1. The result is shown in Table 4 and Fig. 10.

Table 4

| | Coating film structure | Test number | Average of Breakthrough time (s) | Average of diffusion coefficient $D_H$ ($\times$ 10$^{-11}$ m$^2$/s) |
|---|---|---|---|---|
| Comparative example 1 | SUJ2 | 4 | 2,155 | 3.16 |
| Example 4 | SUJ2 + WC film of approximately 0.4 $\mu$m | 2 | 19,925 | 0.374 |

As shown in Table 4 and Fig. 10, Example 4 having the WC film largely extends the Breakthrough time and largely decreases the diffusion coefficient $D_H$, compared to Comparative example 1. The hydrogen diffusion coefficient of the WC film is analyzed by the finite element method (FEM) based on the average shown in Table 4 and is presumed as 3.37 $\times$ 10$^{-12}$ m$^2$/s. Comparing the result of the WC film of Example 4 and the results of the Ni plating coating films of Examples 1 and 2, the advantageous effect of Example 4 is remarkable. In this manner, the hydrogen embrittlement delaying effect can be favorably shown also by forming the WC film as the hard film, on the surface of the base material.

INDUSTRIAL APPLICABILITY

The hard film formed body of the present invention improves the hydrogen embrittlement resistance and the wear resistance and has superior flaking resistance, so that the hard film formed body can be favorably used in a machine component such as a bearing that is used in a hydrogen entering environment.

REFERENCE SIGNS LIST

| | |
|---|---|
| 1: | hard film formed body |
| 2: | base material |
| 3: | hard film |
| 4: | hard film formed body |
| 5: | base material |
| 6: | hard film |
| 7: | intermediate layer |
| 8: | DLC layer |
| 11: | deep groove ball bearing (bearing) |
| 12: | inner ring |
| 13: | outer ring |
| 14: | ball (rolling element) |
| 15: | cage |
| 16: | seal member |
| 17: | grease |
| 18: | hard film |
| 21: | hydrogen circulating pump |
| 22: | motor housing |
| 23: | pump housing |
| 24, 25: | rotational shaft |

| 26: | motor stator |
|---|---|
| 27: | motor rotor |
| 28, 29: | gear |
| 30, 31: | rotor |
| 32, 33, 34, 35, 36, 37: | rolling bearing |
| 41: | test device |
| 42: | cathode bath |
| 43: | electrolytic solution |
| 44: | cathode electrode |
| 45: | anode bath |
| 46: | electrolytic solution |
| 47: | anode electrode |
| 48: | KCl saturated solution |
| 49: | reference electrode |
| 50: | salt bridge |
| 51: | specimen |

**Claims**

1. A hard film formed body comprising: a base material, and a hard film that suppresses entering and diffusing of a hydrogen atom, the hard film being formed on a surface of the base material, wherein:

   (A) a ratio of the Vickers hardness of the hard film to the Vickers hardness of the base material is 0.90-1.20, or
   (B) the thickness of the hard film is 0.1 $\mu$m or more and less than 3 $\mu$m.

2. The hard film formed body as defined in claim 1, that fulfills the feature (A), wherein the Vickers hardness of each of the base material and the hard film is 500-1,000 Hv.

3. The hard film formed body as defined in claim 1, that fulfills the feature (A), wherein the hard film that suppresses the entering and diffusing of the hydrogen atom is a Ni coating film.

4. The hard film formed body as defined in claim 3, wherein the Ni coating film includes a Ni-P-B coating film that contains Ni by 90 mass% or more.

5. The hard film formed body as defined in claim 1, wherein:

   in the electrochemical hydrogen permeation method using a specimen formed of the hard film formed body (the thickness of the base material is 1 mm),
   as each of areas of the specimen that are in contact with electrolytic solutions in a cathode bath and an anode bath, respectively, is set to 3.14 cm$^2$ and the electrolysis is performed at a current density at the side of the anode bath of 1 mA/cm$^2$,
   the extension time of the Breakthrough time of the specimen is 0.4 times or more as long as the Breakthrough time of a target formed of the base material having the thickness of 1 mm.

6. The hard film formed body as defined in claim 1, that fulfills the feature (A), wherein an intermediate layer and a diamond-like carbon layer are formed on the surface of the hard film.

7. The hard film formed body as defined in claim 1, that fulfills the feature (A), wherein:

   the ratio of the Vickers hardness is 0.95-1.05,
   the Vickers hardness of each of the base material and the hard film is 700-800 Hv,
   the hard film that suppresses the entering and diffusing of the hydrogen atom is a Ni coating film,
   the Ni coating film includes a Ni-P-B coating film that contains Ni by 90 mass% or more, and
   an intermediate layer and a diamond-like carbon layer are formed on the surface of the hard film.

8. The hard film formed body as defined in claim 1, that fulfills the feature (B), wherein the hard film that suppresses the entering and diffusing of the hydrogen atom is a tungsten carbide film.

9. The hard film formed body as defined in claim 8, wherein the thickness of the tungsten carbide film is 0.2 $\mu$m or more and less than 1 $\mu$m.

10. A machine component using the hard film formed body as defined in claim 1.

11. The machine component as defined in claim 10, formed as a bearing member.

12. A bearing using the bearing member as defined in claim 11.

Fig.1

Fig.2

Fig.3

Fig.4

Fig.5

Ni PLATING COATING FILM
(HARD FILM)

SUJ2
(BASE MATERIAL)

Fig.6

Fig.7

( a ) OUTLINE OF ELECTROCHEMICAL HYDROGEN PERMEATION TEST

$e^-$           $e^-$

$H_2$

$H_{2ad}$

diffusion

$H^+$

$H^+ \longrightarrow H_{ad} \longrightarrow H_{ab} \longrightarrow H_{ab} \longrightarrow H_{ad}$

cathode-side     specimen     anode-side

( b ) OUTLINE OF HYDROGEN ENTERING FROM HYDROGEN ATMOSPHERE AND DISCHARGED TO AIR

$H_2$    $H_{2ad}$           $H_{2ad} \longrightarrow H_2$

diffusion

$H_{ad} \longrightarrow H_{ab} \longrightarrow H_{ab} \longrightarrow H_{ad}$

entering-side     specimen     outlet-side

Fig.8

WC/DLC COATING FILM
(DLC COATING FILM
AT UPPERMOST SIDE)

Ni PLATING COATING FILM
(HARD FILM)

SUJ2
(BASE MATERIAL)

50 μm

Fig.9

Fig.10

(a)

(b)

# EP 4 527 979 A1

<table>
<tr><td colspan="2" align="center">INTERNATIONAL SEARCH REPORT</td><td colspan="2">International application No.<br><br>**PCT/JP2023/018229**</td></tr>
</table>

**A. CLASSIFICATION OF SUBJECT MATTER**

*C23C 26/00*(2006.01)i; *C23C 14/06*(2006.01)i; *F16C 19/16*(2006.01)i; *F16C 33/32*(2006.01)i; *F16C 33/58*(2006.01)i
FI: C23C26/00 B; C23C14/06 F; C23C26/00 C; F16C19/16; F16C33/32; F16C33/58

According to International Patent Classification (IPC) or to both national classification and IPC

**B. FIELDS SEARCHED**

Minimum documentation searched (classification system followed by classification symbols)

C23C26/00; C23C14/06; F16C19/16; F16C33/32; F16C33/58

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2015-36518 A (TOSHIBA CORP) 23 February 2015 (2015-02-23)<br>paragraphs [0002], [0023]-[0025] | 1, 5, 8-12 |
| A | entire text | 2-4, 6-7 |
| X | JP 2007-56301 A (CITIZEN WATCH CO LTD) 08 March 2007 (2007-03-08)<br>claims 10-11, paragraph [0023] | 1, 5, 8-10 |
| A | entire text | 2-4, 6-7, 11-12 |
| A | JP 11-350163 A (MITSUBISHI ELECTRIC CORP) 21 December 1999 (1999-12-21)<br>entire text | 1-12 |

☐ Further documents are listed in the continuation of Box C.   ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **30 June 2023** | **11 July 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/018229**

| Patent document cited in search report | | | Publication date (day/month/year) | Patent family member(s) | Publication date (day/month/year) |
|---|---|---|---|---|---|
| JP | 2015-36518 | A | 23 February 2015 | (Family: none) | |
| JP | 2007-56301 | A | 08 March 2007 | (Family: none) | |
| JP | 11-350163 | A | 21 December 1999 | (Family: none) | |

Form PCT/ISA/210 (patent family annex) (January 2015)

**REFERENCES CITED IN THE DESCRIPTION**

**Patent documents cited in the description**

- JP 2010043320 A
- JP 2010174360 A
- JP 2005069273 A

**Non-patent literature cited in the description**

- **TAKAHIRO KUSHIDA**. Research on hydrogen embrittlement by electrochemical hydrogen permeation technique. *Zairyo-to-Kankyo*, 2000, vol. 49, 195-200